# EUROPEAN PATENT SPECIFICATION

(11) **EP 2 783 368 B1**
(45) Date of publication and mention of the grant of the patent: **17.04.2019**
(21) Application number: 11793622.9
(22) Date of filing: 22.11.2011
(51) Int. Cl.: G11C 27/02, H03F 3/00, H03F 3/45

(54) **VOLTAGE SENSING CIRCUIT WITH REDUCED SUSCEPTIBILITY TO GAIN DRIFT**
SCHALTUNG ZUR SPANNUNGSMESSUNG MIT VERMINDERTER EMPFINDLICHKEIT GEGENÜBER VERSTÄRKUNGSDRIFT
CIRCUIT DE DÉTECTION DE TENSION AYANT UNE SENSIBILITÉ RÉDUITE À LA DÉRIVE DU GAIN

(43) Date of publication of application: 01.10.2014
(73) Proprietor: Robert Bosch GmbH, 70442 Stuttgart (DE)
(72) Inventor: EZEKWE, Chinwuba, Albany, CA 94706 (US); VANDERHAEGEN, Johan, Cupertino, CA 95014 (US)
(74) Representative: Isarpatent
(86) International application number: PCT/US2011/061946
(87) International publication number: WO 2013/077873

(56) References cited:
- US-A- 5 914 638
- US-A1- 2010 026 536
- US-B1- 7 202 738
- US-B1- 7 535 295

## Description

### TECHNICAL FIELD

This disclosure relates generally to voltage sensing circuits and, more particularly, to voltage sensing circuits at an interface between analog signal and digital signal processing domains.

### BACKGROUND

Many electronic systems and applications measure voltage levels of electrical signals for various purposes. Various electronic circuits often measure the voltage levels of external electrical signals as inputs. In many cases the measured electrical signal is filtered, amplified, or otherwise modified to conform to the operational parameters of the electronic system measuring the signal. In one typical use, analog to digital converters generate a discrete digital encoding that corresponds to measured analog voltage. Once converted, the digital representation of the analog signal is available for use in a wide variety of microelectronic devices. In many cases, an intermediate voltage sensing circuit transforms the electrical signal to improve the accuracy of the analog to digital converter.

Practical implementations of voltage sensing circuits face several challenges to accurate measurement of electrical signals, particularly time varying signals. Some sources of error include offset errors, noise in the source signal and noise introduced by the voltage sensing circuit, aliasing, and gain errors. Some of these errors, such as offset and gain errors, may increase in magnitude over time.

One method of improving the accuracy of voltage sensing circuits is to modulate the electrical signal being measured, and then to demodulate the signal using a voltage to current converter. In particular, modulation and demodulation with "chopped" signals known to the art provides anti-aliasing, filtering, and sampling of the input signal. However, while this technique provides advantages, the voltage to current converter used in the demodulation process remains susceptible to gain drift over time. This drift may result in incremental errors in voltage sensing that have negative effects on circuits and electronic devices measuring electrical signals. Thus, voltage sensing circuits with improved accuracy are desirable.
Document US 7,535,295 relates to a chopper stabilized three stage amplifier which uses a separate voltage to current converter for the input voltage and the feedback voltage and combining both of the current outputs before being input to the chopper.
Document US 5,914,638 discloses system for adjustment of common-mode input to a "predetermined regulating voltage", based on the difference between the common-mode output voltage and a regulating voltage.
The present invention has as its object to provide a voltage sensing circuit which provides high accuracy and a reduction of the effect of gain drift on the output voltage. This object is solved by claim 1 and further advantageous embodiments are listed in the dependent claims. The following aspects discussed separately below contribute to the understanding of the invention before the embodiments of the invention will be described below with reference to the drawings.

### SUMMARY

In one aspect a voltage sensing circuit has been developed. The circuit includes a voltage to current converter having an input for receiving a modulated input voltage, an integrator having an input that is operatively connected to the voltage to current converter, a sample and hold amplifier having an input that is operatively coupled to the integrator, and a first modulator having an input that is operatively connected to the sample and hold amplifier. The voltage to current converter is configured to produce a modulated current. The integrator is configured to receive the modulated current, demodulate the modulated current, and generate a voltage sum of the demodulated current for a predetermined time period. The sample and hold amplifier is configured to sample the voltage sum received from the integrator and provide an output voltage corresponding to the voltage sum. The first modulator is configured to modulate the output voltage of the sample and hold amplifier and provide the modulated voltage as a first feedback signal to the input of the voltage to current converter.

In another aspect, a voltage sensing circuit has been developed. The circuit includes a voltage to current converter having an input for receiving a modulated input voltage, an integrator having an input that is operatively connected to the voltage to current converter, a sample and hold amplifier having an input that is operatively coupled to the integrator, a first modulator having an input that is operatively connected to the sample and hold amplifier, and an incremental analog-to-digital converter having an input that is operatively connected to the sample and hold amplifier. The voltage to current converter is configured to produce a modulated current. The integrator is configured to receive the modulated current, demodulate the modulated current, and generate a voltage sum of the demodulated current for a predetermined time period. The sample and hold amplifier is configured to sample the voltage sum received from the integrator and provide an output voltage corresponding to the voltage sum. The first modulator is configured to modulate the output voltage of the sample and hold amplifier and provide the modulated voltage as a first feedback signal to the input of the voltage to current converter. The incremental analog-to-digital converter receives the output voltage of the sample and hold amplifier.

### BRIEF DESCRIPTION OF THE DRAWINGS

FIG. 1 is a schematic diagram of a system including a voltage sensing circuit having reduced susceptibility to gain drift.
FIG. 2 is a schematic diagram of a first embodiment of a voltage sensing circuit including a feedback loop.
FIG. 3 is a schematic diagram of an alternative embodiment of the voltage sensing circuit of FIG. 2.
FIG. 4 is a schematic diagram of an embodiment of a voltage sensing circuit including a feedback loop and a two-stage Miller operational amplifier circuit.
FIG. 5 is a schematic diagram of an alternative embodiment of the voltage sensing circuit of FIG. 4.
FIG. 6 is a timing diagram depicting exemplary waveforms that may be used with the circuits of FIG. 1 - FIG. 5.

### DETAILED DESCRIPTION

The description below and the accompanying figures provide a general understanding of the environment for the system and method disclosed herein as well as the details for the system and method. In the drawings, like reference numerals are used throughout to designate like elements. As used in this document, the term "voltage to current converter" refers to an amplifier that outputs a current proportional to a voltage applied to an input of the amplifier. Voltage to current converters are also known as transconductance amplifiers, abbreviated as *Gₘ* or *gₘ* in many schematic representations, and may also be referred to as a voltage controlled current source (VCCS). Common physical components that act as voltage to current converters include operational amplifier circuits. The term "pulse train signal" refers to an electrical signal having a series of alternating high and low voltage values that each last for predetermined period of time. The pulse train signal has a generally rectangular waveform. One common form of pulse train is a "square wave" signal that is a pulse train signal having a 50% duty cycle. The terms "integrator" and "integrating amplifier" refer to a circuit that produces a sum voltage of an input signal over a given time period. The integrator may be an inverting amplifier whose sign is the opposite of that of the sum of the input voltages. The term "sample and hold amplifier" refers to an amplifier that is configured to produce an output voltage that is proportional to a received input voltage for a predetermined time period. The sample and hold amplifier is configured to continue producing the output voltage even if the input voltage changes after being sampled. The term "chopper" refers to an electronic switch that is configured to open and close in response to a control signal, such as a pulse train signal. Choppers may modulate or demodulate an input signal.

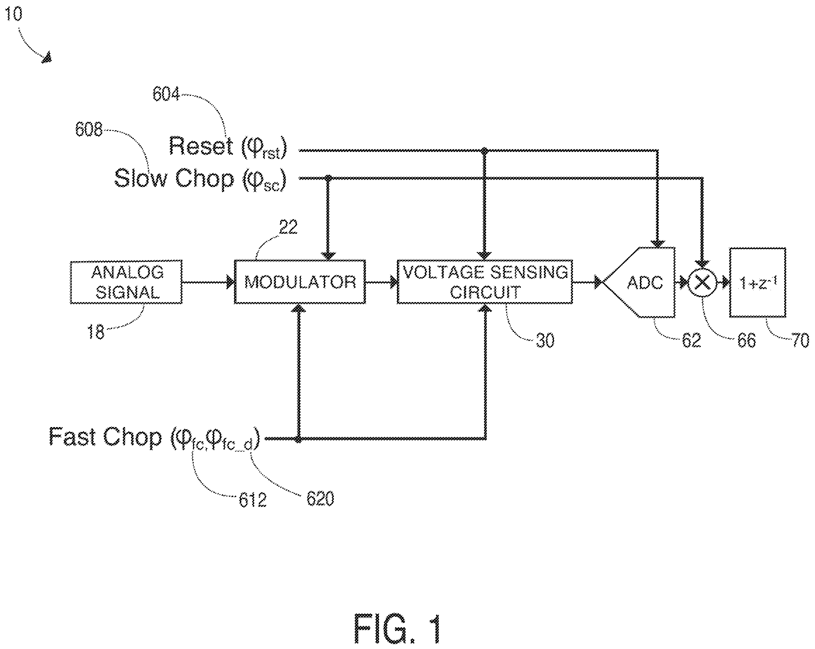

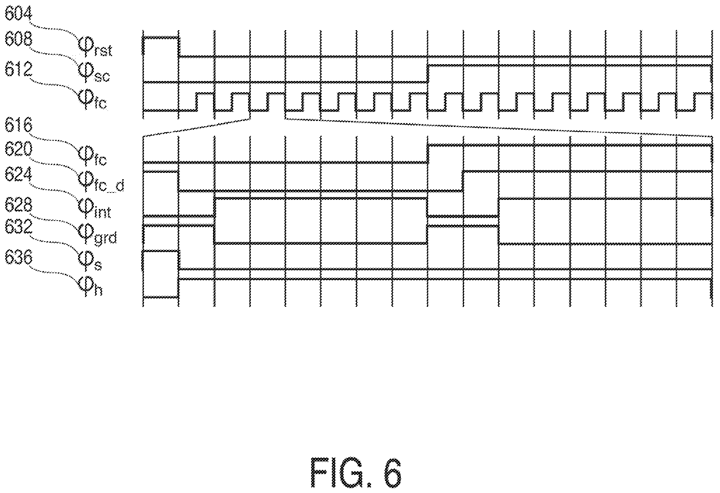

FIG. 1 depicts a system 10 including a voltage sensing circuit 30 configured to measure a voltage of an analog signal 18 for use with an analog to digital converter (ADC) 62. System 10 includes an input configured to receive an analog signal 18, a modulator 22, voltage sensing circuit 30, ADC 62, output modulator 66, and filter 70. A reset signal 604 (FIG. 6), slow-chop signal 608 (FIG. 6), fast-chop signal 612 (FIG. 6), and delayed fast-chop signal 620 (FIG. 6) provide control input to the modulator 22, voltage sensing circuit 30, and ADC 62. An exemplary embodiment of ADC 62 includes a two-stage ∑Δ modulator and decimation filter, although any suitable ADC design may be used. In operation, modulator 22 modulates input signal 18. ADC 62 is configured to operate as an incremental converter that is reset in response to reset signal 604. The voltage sensing circuit 30 demodulates the modulated voltage and provides a correlated measured voltage level to the ADC 62 for each cycle of fast-chop signal 612. The modulation and demodulation filter low-frequency noise that may be present in analog signal 18 and the voltage sensing circuit 30 holds the measured voltage for conversion by ADC 62.

Reset signal 604 zeroes sensed voltages in voltage sensing circuit 30 and ADC 62 after a predetermined period of time has passed. The reset signal 604 asserts at the start of each cycle of a slow-chop signal 608, and each slow-chop signal has a cycle time period that is long enough to allow voltage sensing circuit 30 and ADC 62 to measure and digitize a series of correlated samples for a single voltage level measurement for use by decimation filter 70. Fast-chop signal 612 supplies an input signal to the modulator 22 and voltage sensing circuit 30. An example of a fast-chop signal is a pulse train signal having a frequency of 1 MHz, while the slow-chop signal 608 has a lower frequency, typically in the range of 1/100 to 1/5000 the frequency of the fast-chop signal. Fast-chop signal 612 and delayed fast-chop signal 620 provide the clock signals for modulation and demodulation of the analog signal 18 in the modulator 22 and voltage sensing circuit 30. While voltage modulator 22 and voltage sensing circuit 30 are shown configured to supply a sensed voltage to an ADC in FIG. 1, the same voltage modulator 22 and voltage sensing circuit may be configured for use in various other electronic circuits as well.

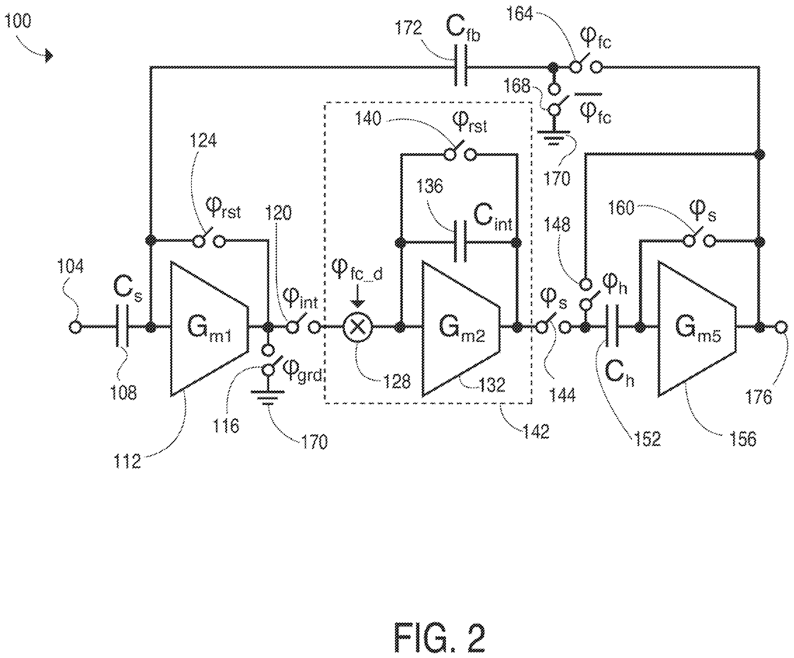

FIG. 2 depicts a voltage sensing circuit 100 suitable for use with the system 10 of FIG. 1. Circuit 100 includes an input terminal 104, input capacitor 108, voltage to current converter 112, integrator 142, sample-and-hold amplifier 156, feedback switches 164 and 168, feedback capacitor 172, and output terminal 176. Integrator 142 includes a demodulator 128, operational amplifier 132, integration capacitor 136, and reset switch 140. Capacitor 108 of this circuit electrically couples the modulated analog signal to the input of the voltage to current converter 112. A feedback signal, described in more detail below, is also coupled to the input of the converter 112. When the voltage sensing circuit 100 begins measuring a new voltage level, reset switch 124 closes in response to a reset signal 604 to enable input capacitor 108 to discharge and begin sampling a new voltage level. After the signal has been converted to a current signal, the signal is operated on by integrator switch 120 and ground switch 116 operating in accordance with integrator signal 624 and ground signal 628, respectively. As seen in FIG. 6, the integrator signal 624 asserts high after a delay from the edges of a single fast-chop signal 616 (FIG. 6), where the delay is known as a guard phase. During the guard phase, integrator switch 120 remains open. The guard phase delay leaves integrator switch 120 open to reject signal artifacts and noise that are generated during modulation and demodulation on the rising and falling edges of fast-chop signal 612. During the guard phase, ground switch 116 couples the output of voltage to current converter 112 to ground 170 in response to ground signal 628 (FIG. 6) to further reduce the effects of noise produced during demodulation.

With further reference to FIG. 2, the signal output through integrator switch 120 is electrically coupled to demodulator 128 and demodulated with reference to the delayed fast chop signal 620. The demodulated signal is provided to integrator 142, which integrates the signal. Switch 144 is closed by sample clock 632 to enable the integrated signal to be sampled by capacitor 152 and then input to amplifier 156. Sample clock 632 opens switch 144 and hold signal 636 closes switch 148, which enables the capacitor 152 and amplifier 156 to hold the sampled signal on the output 176. When the hold signal 636 opens switch 148, the sample and hold amplifier is prepared to sample the next integrated signal. The output signal is also modulated by the action of switches 164 and 168 operating with reference to fast chop signal 612 and its inversion. This feedback signal is electrically coupled to the input of the voltage to current converter 112 by the capacitor 172.

In one embodiment, voltage to current converter 112 is a telescopic cascode that is connected to input capacitor 108, reset switch 124, ground switch 116, and integrator switch 120. The telescopic cascode isolates noise that may be present in the input signal from the output, although any voltage to current converter that is configured to receive modulating inputs from input capacitor 108 may be used.

Demodulator 128 is embodied as a chopper in FIG. 2. The demodulator receives the output current of voltage to current converter 112 as a modulated, alternating current signal. Since the input signal received by the voltage sensing circuit 100 is modulated, the corresponding output current from voltage to current converter 112 is also modulated. The demodulator removes the modulation using a demodulation signal that corresponds to the modulation signal used to modulate the input, and also removes residual offset voltage from the voltage to current converter 112. In the example of FIG. 2, the demodulation signal is a pulse train signal having a delayed fast-chop waveform 620 that is phase-shifted by one half a cycle from the fast-chop signal 616. A similar pulse train waveform modulates the input signal prior to the signal reaching voltage to current converter 112. The delayed timing of signal 620 reduces noise introduced by the demodulator 128 when the sample-and-hold amplifier 156 samples the voltage sum of integrator 142, as is described in more detail below.

The demodulator 128 is shown as part of an integrator 142 that further includes operational amplifier 132 and integration capacitor 136. In one embodiment, the operational amplifier 132 and capacitor 136 provide a direct current gain of at least 150 dB to produce a closed-loop gain of 58 dB with 90 dB of linearity. The demodulated output current of demodulator 128 forms a charge in integrator capacitor 136 that accumulates over time as the voltage sum of the integrator 142. The voltage sum includes voltages summed from previous cycles of fast-chop signal 612 during a single period of slow-chop signal 608 as well as an additional voltage added for the current fast-chop cycle 616. A reset switch 140 zeroes the stored charge in integration capacitor 136, and consequently the voltage sum, in response to reset signal 604 at the beginning of each cycle of slow-chop signal 608.

In response to sampling signal 632, the switches 144 and 160 couple the output of the integrator to hold capacitor 152, and couple the input and output of the sample and hold amplifier 156 to one another. Hold capacitor 152 receives a charge that corresponds to the voltage sum of integrator 142. After the sample period is over, hold switch 148 couples the input of hold capacitor 152 to the output of operational amplifier 156 in response to hold signal 636 (FIG. 6) while switches 144 and 160 open. During the hold period, which lasts for the majority of the each fast-chop 616 cycle, the sample and hold amplifier 156 produces an output that corresponds to the voltage charge of hold capacitor 152. An ADC, such as ADC 62 seen in FIG. 1, or other electronic circuits may receive the output voltage through terminal 176. In systems where an ADC samples the output of sample and hold amplifier 156, each fast-chop cycle during a single slow-chop cycle produces a single sample that the ADC uses in producing a single decimated output. A typical number of fast-chop cycles 612 and samples for each slow-chop cycle 608 that generates an ADC output is 4096. After each series of fast-chop cycles, the reset signal that zeros the integration capacitor 136 also zeros hold capacitor 152, resetting the circuit 100 to begin measuring a new voltage level. The output of sample and hold amplifier 156 is also connected to feedback switch 164.

As noted above, the action of the modulator switches 164 and 168 modulates the output of the sample and hold amplifier. Switch 164 has terminals connected to the sample and hold amplifier 156 and feedback capacitor 172, while switch 168 is connected to feedback capacitor 172 and electrical ground 170. Modulator switches 164 and 168 open and close in response to the fast-chop signal 616, with switch 164 opening and closing in response to the fast-chop signal 616, while switch 168 opens and closes in response to the logical inverse of fast-chop signal 616. Thus, during the first half of each cycle of fast-chop signal 616, switch 168 couples feedback capacitor 172 with ground 170, and during the second half of fast-chop cycle 616, switch 164 couples the output of the sample and hold amplifier 156 to the feedback capacitor 172. The operation of switches 164 and 168 applies a square wave modulation to the output signal of the sample and hold amplifier 156, providing a modulated voltage signal using the same modulation technique as the modulated input signal supplied to the voltage to current converter 112. Switches 164 and 168 are merely illustrative of one modulation circuit, and other embodiments, including using a single three-pole switch, are also envisioned.

The output of feedback capacitor 172 connects to the input of the voltage to current converter 112. In operation, the voltage to current converter 112 may experience gain drift. The modulated feedback signal reduces or eliminates the effect of the gain drift on the output voltage produced by the sample and hold amplifier 156 by applying a negative feedback to cancel the effects of gain drift in the input to voltage to current converter 112. The modulation in the feedback loop enables the use of feedback capacitor 172 in the feedback loop. The feedback capacitor 172 and input capacitor 108 enable noiseless summation of the input voltage signal while also providing a high-impedance load to analog signal source driving the input terminal 104 using a single input stage.

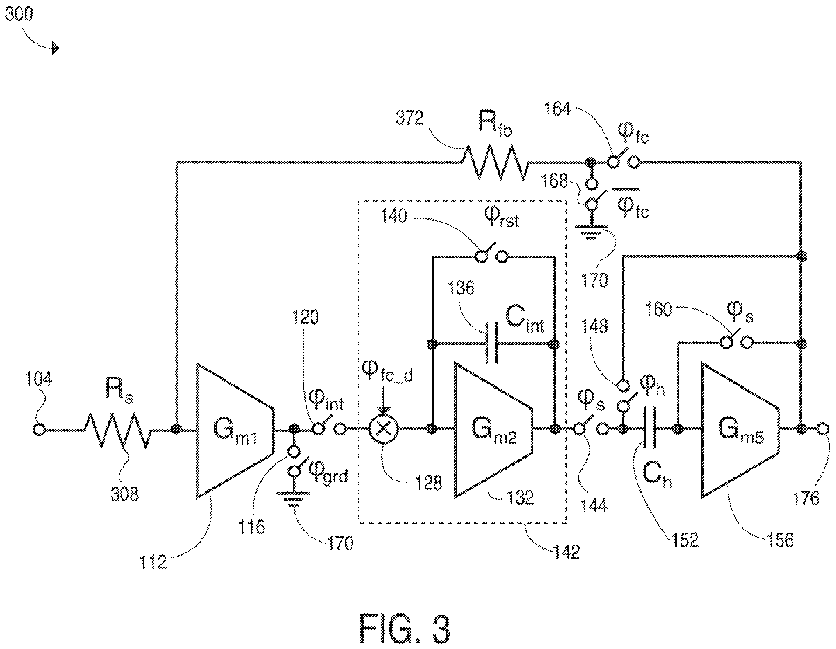

FIG. 3 depicts an alternative voltage sensing circuit 300. The circuit 300 includes the input terminal 104, voltage to current converter 112, demodulator 128, operational amplifier 132, integration capacitor 136, hold capacitor 152, sample-and-hold amplifier 156, feedback switches 164 and 168, and output terminal 176 described above with reference to FIG. 2. Circuit 300 includes an input resistor 308 and feedback resistor 372, which replace the input capacitor 108 and feedback capacitor 172, respectively. Due to the memoryless nature of input resistor 308, circuit 300 omits the reset switch 124 used to zero input capacitor 108 in FIG. 2.

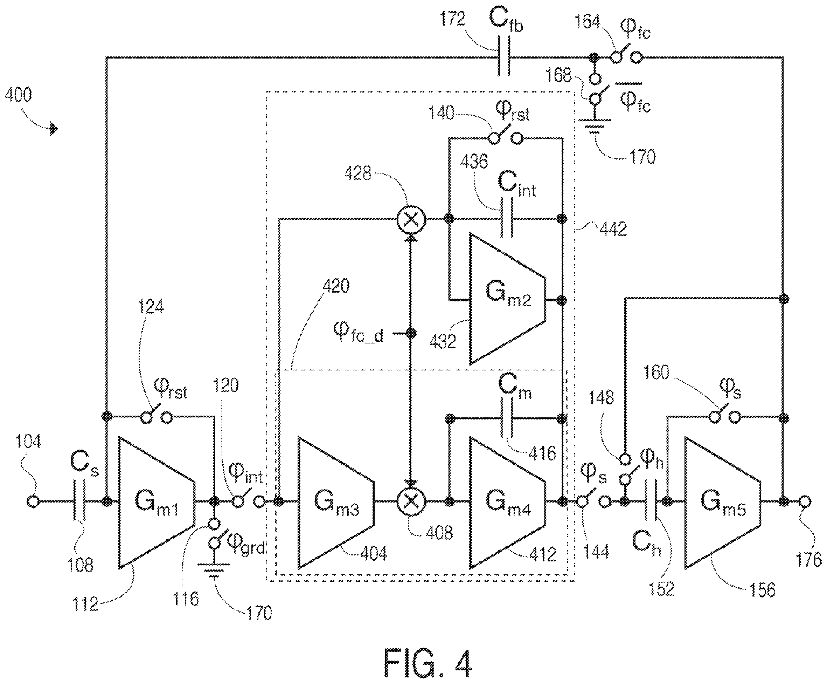

FIG. 4 depicts a voltage sensing circuit 400 with a two-stage Miller amplifier used in an integrator 442. Circuit 400 shares common components with the circuit 100 seen in FIG. 2, including an input terminal 104, input capacitor 108, voltage to current converter 112, hold capacitor 152, sample-and-hold amplifier 156, feedback switches 164 and 168, feedback capacitor 172, and output terminal 176. Integrator 442 includes demodulator 428, amplifier 432, integration capacitor 436, reset switch 140, and a two-stage Miller operational amplifier 420 that further includes a first-stage operational amplifier 404, second demodulator 408, second stage operational amplifier 412, and Miller capacitor 416.

The two-stage Miller amplifier 420 and integration capacitor 436 produces a voltage sum for integrator 442. The first-stage operational amplifier 404 amplifies the modulated current received from voltage to current converter 112 through the integrator switch 120. The amplified modulated current is an alternating current. The second demodulator 408 demodulates the amplified modulated current from first-stage operational amplifier 404. Demodulator 408 is shown as a chopper that is similar to the chopper of demodulator 128 shown above. The delayed fast-chop signal 620 drives demodulator 408 to generate a demodulated output current for the input of the second stage operational amplifier 412. The second stage operational amplifier 412 has an output connected to the integration capacitor 436 that is coupled to hold capacitor 152 by sampling switch 144. Capacitor 416 in the Miller amplifier is a feedback capacitor connected to the output and input of operational amplifier 412.

In operation, the first stage Miller amplifier 404 amplifies the modulated current generated by voltage to current converter 112. The second stage amplifier 420 and Miller capacitor 416 provide an input voltage to the integration capacitor 436 that corresponds to the demodulated and amplified current. The integration capacitor 436 accumulates a charge over time in response to the input voltage to generate a voltage sum for the integrator 442. The voltage sum includes voltages summed from previous cycles of fast-chop signal 612 during a single period of slow-chop signal 608 as well as an additional voltage added for the current fast-chop cycle 616. A reset switch 140 zeroes the stored charge in integration capacitor 436, and consequently the voltage sum, in response to reset signal 604 at the beginning of each cycle of slow-chop signal 608.

Miller operational amplifiers 404 and 412 have a signal response that introduces a zero in the right-hand complex plane of a pole-zero plot known to those in the art. This right-hand zero is susceptible to variance during operation that could introduce inaccuracies into the integration capacitor 436 and the hold capacitor 152 over time. Integrator 442 includes amplifier 432 and demodulator 428 to partially or fully cancel the right-hand zero and stabilize the output of integrator 442. The delayed fast-chop signal drives demodulator 428, which is shown here as a chopper similar to chopper 408. Demodulator 428 demodulates the output current of voltage to current converter 112 and provides the demodulated current to amplifier 432. The output of amplifier 432 is connected to the integrator capacitor 436. The output of amplifier 432 tends to cancel the right-hand zero component in the output signal of two-stage Miller amplifier 420. Thus, the input of integration capacitor 436 receives the output of the two-stage Miller amplifier 420 with the right-hand zero signal component reduced or eliminated to provide for more accurate voltage sums. In operation, the circuit of FIG. 4 provides a similar voltage sensing function to the function described above with reference to FIG. 2.

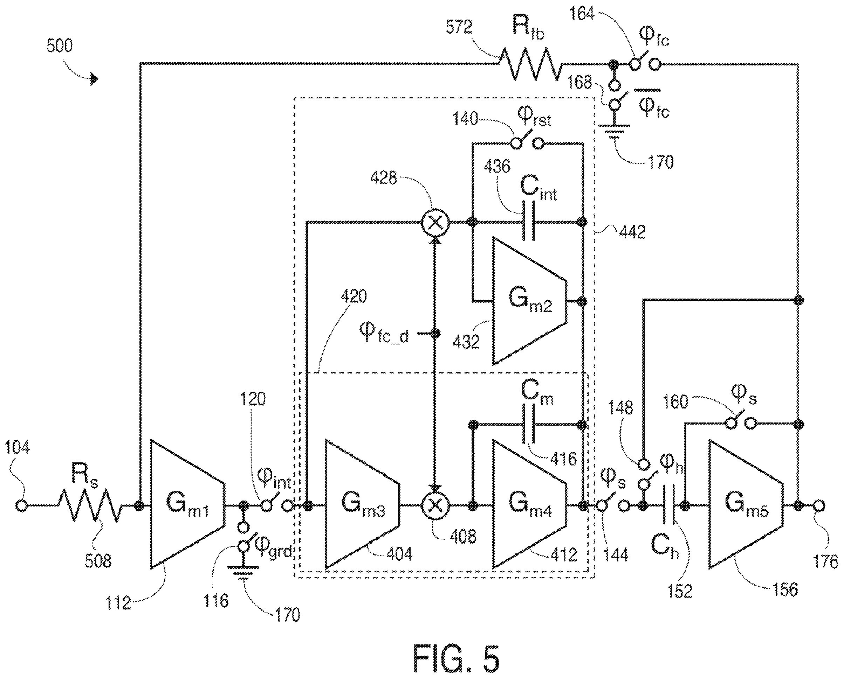

FIG. 5 depicts an alternative voltage sensing circuit 500 that is similar to the circuit of FIG. 4. The circuit 500 includes the input terminal 104, voltage to current converter 112, hold capacitor 152, sample-and-hold amplifier 156, feedback switches 164 and 168, and output terminal 176 described above with reference to FIG. 2. The circuit 500 also includes an integrator 442 having a demodulator 428, amplifier 432, integration capacitor 436, reset switch 140, and two-stage Miller amplifier 420. The two-stage Miller amplifier 420 includes first-stage amplifier 404, demodulator 408, second-stage amplifier 412, and Miller capacitor 416 as described above with reference to FIG. 4. Circuit 500 includes an input resistor 508 and feedback resistor 572 that replace the input capacitor 108 and feedback capacitor 172, respectively. Due to the memoryless nature of input resistor 508, circuit 300 omits the reset switch 124 used to zero input capacitor 108 in FIG. 4.

FIG. 6 depicts a timing diagram of control signals that are suitable for use with the circuits described above. The signals include a reset signal 604, slow-chop signal 608, fast-chop signal 612, a time-scaled representation of the fast-chop signal 616, a delayed fast-chop signal 620, integrator signal 624, ground signal 628, sample signal 632, and hold signal 636. The timing of reset signal 604 corresponds to the slow-chop signal 608 so that the reset signal asserts once for each slow-chop signal cycle. Signals 616-636 depict a time-scaled view of signal activity that occurs during a single cycle of fast-chop signal 612. When read with reference to the foregoing figures, a "high" assertion in a signal indicates that a corresponding switch is closed in response to the asserted signal. For example, integrator switch 120 is closes in response to integrator signal 624 asserting high, and opens when integrator signal 624 is low. These signals are described above with respect to particular components and operations of the circuits

Those skilled in the art will recognize that numerous modifications can be made to the specific implementations described above. For example, while the embodiments of FIG. 1 - FIG. 5 depict single-ended voltage sensing circuits having a single input, alternative embodiments may include differential voltage sensing circuits that are configured to sense voltage levels between a plurality of inputs.

## Claims

1. A voltage sensing circuit (10) comprising:
a voltage to current converter (112) having an input for receiving a modulated input voltage and a modulated feedback voltage, the voltage to current converter (112) being configured to produce a modulated current;
an integrator (142) having an input that is operatively connected to the voltage to current converter (112) to receive the modulated current, the integrator (142) being configured to demodulate the modulated current and to generate a voltage sum of the demodulated current for a predetermined time period, the integrator (142) further comprising
a first demodulator (128) having an input that is operatively connected to the voltage to current converter (112) to receive the modulated current, the demodulator (128) being configured to produce a first demodulated current, the demodulator (128) being a chopper (128) having an input to receive the modulated current, the chopper (128) being configured to demodulate the modulated current with a delayed signal (620) of a first frequency;
a first operational amplifier (132) having an input to receive the first demodulated current, the operational amplifier (132) being configured to generate a voltage; and
a first capacitor (136) having an input to receive the voltage generated by the first operational amplifier (132), the first capacitor (136) being configured to generate the voltage sum of the first demodulated current for the predetermined time period;
a sample and hold amplifier (156) having an input that is operatively coupled to the integrator (142) to receive the voltage sum, the sample and hold amplifier (156) being configured to sample a voltage sum received from the integrator (142) and provide an output voltage corresponding to the voltage sum; and
a first modulator (164, 168) having an input that is operatively connected to the sample and hold amplifier (156) to receive the output voltage, the first modulator (164, 168) being configured to modulate the output voltage of the sample and hold amplifier (156) and provide the modulated feedback voltage to the input of the voltage to current converter (112), the first modulator (164, 168) further comprising
a switching circuit (164, 168) operatively connected to the sample and hold amplifier (156) and operated with the signal (612) having the first frequency to produce the modulated feedback voltage; and
either
a second capacitor (108) configured to couple the modulated input voltage to the input of the voltage to current converter (112); and
a third capacitor (172) configured to couple the modulated feedback voltage to the input of the voltage to current converter (112);
or
a first resistor (308, 508) configured to couple the modulated input voltage to the input of the voltage to current converter (112); and a second resistor (372, 572) configured to couple the modulated feedback voltage to the input of the voltage to current converter (112);
the voltage sensing circuit (10) further comprising:
a modulation input circuit (22) configured to modulate an input signal (18) with a signal (612) having the first frequency followed by a modulation of the input signal (18) with a signal (608) having a second frequency, the first frequency being greater than the second frequency; and
an incremental analog-to-digital converter (62) having an input that is operatively connected to the sample and hold amplifier (156) to receive the output voltage, the incremental analog-to-digital converter (62) being configured to be reset with reference to a signal (604) corresponding to the second frequency.

2. The circuit (10) of claim 1, wherein the voltage to current converter (112) further comprises: a telescopic cascode circuit (112) configured to receive the modulated input voltage and track a common mode input level of at least one input device to maintain substantially constant drain to source voltages in the at least one input device.

3. The circuit (10) of claim 1 wherein the signal (612) having the first frequency has a pulse train wave form.

4. The circuit (10) of claim 1, wherein the integrator further comprises:
a second operational amplifier (404) having an input to receive the modulated current from the voltage to current converter (112), the second operational amplifier (404) being configured to generate an alternating current signal;
a second demodulator (408) having an input to receive the alternating current signal, the second demodulator (408) being configured to generate a second demodulated current;
a second operational amplifier (412) having an input to receive the second demodulated current, the second operational amplifier (412) being configured to generate a voltage;
a fourth capacitor (416) having an input to receive the voltage generated by the second operational amplifier (412), the fourth capacitor (416) being configured to generate the voltage sum of the second demodulated current for the predetermined time period;
the first operational amplifier (132, 432) being configured to produce an offset cancellation voltage that is coupled to the input of the fourth capacitor (416) to modify the voltage sum, the offset cancellation voltage corresponds to a component of the voltage generated by the second operational amplifier (412).

5. The circuit (10) of claim 4 further comprising: the second demodulator (408) being a chopper (408) having an input to receive the alternating current signal, the chopper (408) being configured to demodulate the alternating current signal with a delayed signal (620) of the first frequency.

## Patentansprüche

1. Schaltung zur Spannungsmessung (10), die Folgendes umfasst:
einen Spannungs-Strom-Wandler (112) mit einem Eingang zum Empfangen einer modulierten Eingangsspannung und einer modulierten Rückkopplungsspannung, wobei der Spannungs-Strom-Wandler (112) dazu ausgelegt ist, einen modulierten Strom zu erzeugen;
einen Integrator (142) mit einem Eingang, der mit dem Spannungs-Strom-Wandler (112) wirkverbunden ist, um den modulierten Strom zu empfangen, wobei der Integrator (142) dazu ausgelegt ist, den modulierten Strom zu demodulieren und eine Spannungssumme des demodulierten Stroms für eine vorbestimmte Zeitspanne zu erzeugen, wobei der Integrator (142) ferner Folgendes umfasst einen ersten Demodulator (128) mit einem Eingang, der mit dem Spannungs-Strom-Wandler (112) wirkverbunden ist, um den modulierten Strom zu empfangen, wobei der Demodulator (128) dazu ausgelegt ist, einen ersten demodulierten Strom zu produzieren, wobei der Demodulator (128) ein Zerhacker (128) mit einem Eingang zum Empfangen des modulierten Stroms ist, wobei der Zerhacker (128) dazu ausgelegt ist, den modulierten Strom mit einem verzögerten Signal (620) einer ersten Frequenz zu demodulieren;
einen ersten Operationsverstärker (132) mit einem Eingang zum Empfangen des ersten demodulierten Stroms, wobei der Operationsverstärker (132) dazu ausgelegt ist, eine Spannung zu erzeugen; und
einen ersten Kondensator (136) mit einem Eingang zum Empfangen der durch den ersten Operationsverstärker (132) erzeugten Spannung, wobei der erste Kondensator (136) dazu ausgelegt ist, die Spannungssumme des ersten demodulierten Stroms für die vorbestimmte Zeitspanne zu erzeugen;
einen Abtast- und Halteverstärker (156) mit einem Eingang, der mit dem Integrator (142) wirkgekoppelt ist, um die Spannungssumme zu empfangen, wobei der Abtast- und Halteverstärker (156) dazu ausgelegt ist, eine vom Integrator (142) empfangene Spannungssumme abzutasten und eine Ausgangsspannung entsprechend der Spannungssumme bereitzustellen; und
einen ersten Modulator (164, 168) mit einem Eingang, der mit dem Abtast- und Halteverstärker (156) wirkverbunden ist, um eine Ausgangsspannung zu empfangen, wobei der erste Modulator (164, 168) dazu ausgelegt ist, die Ausgangsspannung des Abtast- und Halteverstärkers (156) zu modulieren und die modulierte Rückkopplungsspannung am Eingang des Spannungs-Strom-Wandlers (112) bereitzustellen, wobei der erste Modulator (164, 168) ferner Folgendes umfasst eine Umschaltschaltung (164, 168), mit dem Abtast- und Halteverstärker (156) wirkverbunden und mit dem Signal (612), das die erste Frequenz hat, betrieben, um die modulierte Rückkopplungsspannung zu produzieren; und entweder
einen zweiten Kondensator (108), dazu ausgelegt, die modulierte Eingangsspannung mit dem Eingang des Spannungs-Strom-Wandlers (112) zu koppeln; und
einen dritten Kondensator (172), dazu ausgelegt, die modulierte Rückkopplungsspannung mit dem Eingang des Spannungs-Strom-Wandlers (112) zu koppeln; oder
einen ersten Widerstand (308, 508), dazu ausgelegt, die modulierte Eingangsspannung mit dem Eingang des Spannungs-Strom-Wandlers (112) zu koppeln; und einen zweiten Widerstand (372, 572), dazu ausgelegt, die modulierte Rückkopplungsspannung mit dem Eingang des Spannungs-Strom-Wandlers (112) zu koppeln; wobei die Schaltung zur Spannungsmessung (10) ferner Folgendes umfasst:
eine Modulationseingangsschaltung (22), dazu ausgelegt, ein Eingangssignal (18) mit einem Signal (612), das die erste Frequenz hat, zu modulieren, gefolgt von einer Modulation des Eingangssignals (18) mit einem Signal (608), das eine zweite Frequenz hat, wobei die erste Frequenz größer als die zweite Frequenz ist; und
einen inkrementellen Analog-zu-Digital-Wandler (62) mit einem Eingang, der mit dem Abtast- und Halteverstärker (156) wirkverbunden ist, um die Ausgangsspannung zu empfangen, wobei der inkrementelle Analog-zu-Digital-Wandler (62) dazu ausgelegt ist, mit Bezug auf ein Signal (604) entsprechend der zweiten Frequenz zurückgesetzt zu werden.

2. Schaltung (10) nach Anspruch 1, wobei der Spannungs-Strom-Wandler (112) ferner Folgendes umfasst:
eine teleskopische Kaskadenschaltung (112), dazu ausgelegt, die modulierte Eingangsspannung zu empfangen und einen Gleichtakteingangspegel von zumindest einer Eingabevorrichtung zu verfolgen, um im Wesentlichen konstante Senke-zu-Quelle-Spannungen in der zumindest einen Eingabevorrichtung aufrechtzuerhalten.

3. Schaltung (10) nach Anspruch 1, wobei das Signal (612), das die erste Frequenz hat, eine Impulsfolgenwellenform aufweist.

4. Schaltung (10) nach Anspruch 1, wobei der Integrator ferner Folgendes umfasst:
einen zweiten Operationsverstärker (404) mit einem Eingang zum Empfangen des modulierten Stroms vom Spannungs-Strom-Wandler (112), wobei der zweite Operationsverstärker (404) dazu ausgelegt ist, ein Wechselstromsignal zu erzeugen;
einen zweiten Demodulator (408) mit einem Eingang zum Empfangen des Wechselstromsignals, wobei der zweite Demodulator (408) dazu ausgelegt ist, einen zweiten demodulierten Strom zu erzeugen;
einen zweiten Operationsverstärker (412) mit einem Eingang zum Empfangen des zweiten demodulierten Stroms, wobei der zweite Operationsverstärker (412) dazu ausgelegt ist, eine Spannung zu erzeugen;
einen vierten Kondensator (416) mit einem Eingang zum Empfangen der durch den zweiten Operationsverstärker (412) erzeugten Spannung, wobei der vierte Kondensator (416) dazu ausgelegt ist, die Spannungssumme des zweiten demodulierten Stroms für die vorbestimmte Zeitspanne zu erzeugen;
wobei der erste Operationsverstärker (132, 432) dazu ausgelegt ist, eine Offset-Unterdrückungsspannung zu produzieren, die mit dem Eingang des vierten Kondensators (416) gekoppelt ist, um die Spannungssumme zu modifizieren, wobei die Offset-Unterdrückungsspannung einer Komponente der durch den zweiten Operationsverstärker (412) erzeugten Spannung entspricht.

5. Schaltung (10) nach Anspruch 4, die ferner umfasst:
dass der zweite Demodulator (408) ein Zerhacker (408) mit einem Eingang zum Empfangen des Wechselstromsignals ist, wobei der Zerhacker (408) dazu ausgelegt ist, das Wechselstromsignal mit einem verzögerten Signal (620) der ersten Frequenz zu demodulieren.

## Revendications

1. Circuit de détection de tension (10) comprenant :
un convertisseur tension-courant (112) ayant une entrée pour recevoir une tension d'entrée modulée et une tension de rétroaction modulée, le convertisseur tension-courant (112) étant configuré pour produire un courant modulé ;
un intégrateur (142) ayant une entrée qui est raccordée de manière fonctionnelle au convertisseur tension-courant (112) pour recevoir le courant modulé, l'intégrateur (142) étant configuré pour démoduler le courant modulé et pour générer une somme de tensions du courant démodulé pendant une période de temps prédéterminée, l'intégrateur (142) comprenant en outre un premier démodulateur (128) ayant une entrée qui est raccordée de manière fonctionnelle au convertisseur tension-courant (112) pour recevoir le courant modulé, le démodulateur (128) étant configuré pour produire un premier courant démodulé, le démodulateur (128) étant un hacheur (128) ayant une entrée pour recevoir le courant modulé, le hacheur (128) étant configuré pour démoduler le courant modulé avec un signal retardé (620) d'une première fréquence ;
un premier amplificateur opérationnel (132) ayant une entrée pour recevoir le premier courant démodulé, l'amplificateur opérationnel (132) étant configuré pour générer une tension ; et
un premier condensateur (136) ayant une entrée pour recevoir la tension générée par le premier amplificateur opérationnel (132), le premier condensateur (136) étant configuré pour générer la somme de tensions du premier courant démodulé pendant la période de temps prédéterminée ;
un amplificateur échantillonneur-bloqueur (156) ayant une entrée qui est couplée de manière fonctionnelle à l'intégrateur (142) pour recevoir la somme de tensions, l'amplificateur échantillonneur-bloqueur (156) étant configuré pour échantillonner une somme de tensions reçue de l'intégrateur (142) et pour fournir une tension de sortie correspondant à la somme de tensions ; et
un premier modulateur (164, 168) ayant une entrée qui est raccordée de manière fonctionnelle à l'amplificateur échantillonneur-bloqueur (156) pour recevoir la tension de sortie, le premier modulateur (164, 168) étant configuré pour moduler la tension de sortie de l'amplificateur échantillonneur-bloqueur (156) et pour fournir la tension de rétroaction modulée à l'entrée du convertisseur tension-courant (112), le premier modulateur (164, 168) comprenant en outre
un circuit de commutation (164, 168) raccordé de manière fonctionnelle à l'amplificateur échantillonneur-bloqueur (156) et mis en fonctionnement avec le signal (612) ayant la première fréquence pour produire la tension de rétroaction modulée ; et
soit un deuxième condensateur (108) configuré pour coupler la tension d'entrée modulée à l'entrée du convertisseur tension-courant (112), et
un troisième condensateur (172) configuré pour coupler la tension de rétroaction modulée à l'entrée du convertisseur tension-courant (112) ;
soit une première résistance (308, 508) configurée pour coupler la tension d'entrée modulée à l'entrée du convertisseur tension-courant (112) ; et une seconde résistance (372, 572) configurée pour coupler la tension de rétroaction modulée à l'entrée du convertisseur tension-courant (112) ;
le circuit de détection de tension (10) comprenant en outre :
un circuit d'entrée de modulation (22) configuré pour moduler un signal d'entrée (18) avec un signal (612) ayant la première fréquence suivi par une modulation du signal d'entrée (18) avec un signal (608) ayant une seconde fréquence, la première fréquence étant plus importante que la seconde fréquence ; et
un convertisseur analogique-numérique incrémental (62) ayant une entrée qui est raccordée de manière fonctionnelle à l'amplificateur échantillonneur-bloqueur (156) pour recevoir la tension de sortie, le convertisseur analogique-numérique incrémental (62) étant configuré pour être réinitialisé en se référant à un signal (604) correspondant à la seconde fréquence.

2. Circuit (10) selon la revendication 1, dans lequel le convertisseur tension-courant (112) comprend en outre :
un circuit cascode télescopique (112) configuré pour recevoir la tension d'entrée modulée et pour suivre un niveau d'entrée en mode commun d'au moins un dispositif d'entrée pour conserver des tensions drain-source sensiblement constantes dans le ou les dispositifs d'entrée.

3. Circuit (10) selon la revendication 1, dans lequel le signal (612) ayant la première fréquence présente une forme d'onde de train d'impulsions.

4. Circuit (10) selon la revendication 1, dans lequel l'intégrateur comprend en outre :
un second amplificateur opérationnel (404) ayant une entrée pour recevoir le courant modulé en provenance du convertisseur tension-courant (112), le second amplificateur opérationnel (404) étant configuré pour générer un signal de courant alternatif ;
un second démodulateur (408) ayant une entrée pour recevoir le signal de courant alternatif, le second démodulateur (408) étant configuré pour générer un second courant démodulé ;
un second amplificateur opérationnel (412) ayant une entrée pour recevoir le second courant démodulé, le second amplificateur opérationnel (412) étant configuré pour générer une tension ;
un quatrième condensateur (416) ayant une entrée pour recevoir la tension générée par le second amplificateur opérationnel (412), le quatrième condensateur (416) étant configuré pour générer la somme de tensions du second courant démodulé pendant la période de temps prédéterminée ;
le premier amplificateur opérationnel (132, 432) étant configuré pour produire une tension d'annulation de décalage qui est couplée à l'entrée du quatrième condensateur (416) pour modifier la somme de tensions, la tension d'annulation de décalage correspond à une composante de la tension générée par le second amplificateur opérationnel (412).

5. Circuit (10) selon la revendication 4, comprenant en outre :
le second démodulateur (408) étant un hacheur (408) ayant une entrée pour recevoir le signal de courant alternatif, le hacheur (408) étant configuré pour démoduler le signal de courant alternatif avec un signal retardé (620) de la première fréquence.
